# FASCICULE DE BREVET EUROPEEN

(11) **EP 2 772 936 B1**
(45) Date de publication et mention de la délivrance du brevet: **29.12.2021**
(21) Numéro de dépôt: 14157235.4
(22) Date de dépôt: 28.02.2014
(51) Int. Cl.: H01L 23/49, H01L 23/66

(54) **Procédé d'interconnexion par fils paralleles ainsi qu'un procédé d'adaptation des formes de ceux-ci, et les outillages relatifs**
Drahtverbindungsverfahren für Paralleldrähte sowie ein Verfahren zur Umformung derselben, sowie die entsprechende Arbeitsgeräte
Method of wire bonding parallel bond wires aswell as a reshaping process of the same, and the related apparatus

(30) Priorité: 01.03.2013 FR 1300465
(43) Date de publication de la demande: 03.09.2014
(73) Titulaire: THALES, 92400 Courbevoie (FR)
(72) Inventeur: Denis, Stéphane, 35340 ETRELLES (FR); Leduc, Dominique, 35340 ETRELLES (FR); Fortel, Julien, 35340 ETRELLES (FR); Fouin, Patrick, 35340 ETRELLES (FR); Briantais, Didier, 35340 ETRELLES (FR)
(74) Mandataire: Marks & Clerk France

(56) Documents cités:
- JP-A- 2004 296 468
- JP-A- 2005 064 248
- JP-A- 2009 158 839
- JP-B2- 2 897 086
- US-A1- 2006 175 712
- US-A1- 2009 079 081
- LEE H-Y: "WIDEBAND CHARACTERIZATION OF MUTUAL COUPLING BETWEEN HIGH DENSITY BONDING WIRES", IEEE MICROWAVE AND GUIDED WAVE LETTERS, IEEE INC, NEW YORK, US, vol. 4, no. 8, 1 août 1994 (1994-08-01), pages 265-267, XP000458790, ISSN: 1051-8207, DOI: 10.1109/75.267679

## Description

La présente invention concerne un procédé d'interconnexion pour circuits électroniques, notamment des circuits électroniques hyperfréquence, par fils parallèles couplés. La présente invention a également pour objet un outillage pour la réalisation d'une interconnexion au moyen du procédé. Elle s'applique notamment aux liaisons électroniques entre différents circuits électroniques.

La présente invention concerne des applications pour lesquelles des liaisons électriques sont requises, entre différents circuits électroniques. Pour la suite, la notion de circuit électronique est à comprendre dans son acception la plus large, c'est-à-dire qu'un circuit électronique peut se présenter sous la forme d'un module électronique, par exemple d'une puce, d'un microsystème électromécanique, habituellement désigné sous l'acronyme de "MEMS", pour l'expression anglo-saxonne de "Micro-Electro-Mechanical System", d'un circuit intégré en boîtier, d'un module de cartes imprimées simples ou empilées, d'un module tridimensionnel, etc. Ces liaisons peuvent relier électriquement des circuits électroniques physiquement homogènes : par exemple des puces entre elles, ou bien des circuits électroniques physiquement hétérogènes, lorsqu'il s'agit par exemple de relier électriquement une puce à un support d'interconnexion avec un substrat, une carte imprimée, un boîtier, etc. Les signaux considérés peuvent être de caractère numérique rapide ou bien analogique hyperfréquence.

Plus particulièrement, la présente invention se rapporte à des applications dans lesquelles les liaisons électriques précitées sont destinées à la transmission de signaux électriques occupant une large bande de fréquences, et/ou qui se situent dans des fréquences élevées en regard des dimensions des liaisons à réaliser, et/ou qui présentent des puissances élevées. Les signaux considérés peuvent être de nature analogique ou numérique. Il est par exemple considéré que des fréquences élevées en regard des dimensions des liaisons à réaliser, répondent à l'inégalité ll>3.10⁹/1000.f, Il représentant la longueur de liaison en mètres, et f la fréquence du signal transmis, en Hertz.

Lorsque cette inégalité n'est pas satisfaite, la liaison réalisée est d'autant plus difficile à compenser que l'impédance caractéristique des interfaces est faible, que le niveau d'adaptation requis est élevé, et que la bande de fréquences d'intérêt est large. L'implantation d'un réseau d'adaptation n'est pas toujours possible, soit parce que la place disponible est insuffisante, soit parce que les éléments à interconnecter sont figés et non modifiables.

Dans le but de limiter l'influence parasite des éléments de liaison, réalisés par exemple sous la forme de fils ou de rubans, les circuits électroniques qui doivent être reliés électriquement sont placés à la plus grande proximité possible les uns des autres. Les fixations entre les éléments sont par exemple réalisées par des techniques de thermo-compression ou de thermo-sonie. En conséquence, les dimensions et les tolérances qui y sont associées et qui sont associées au positionnement des éléments, sont réduites, au détriment des coûts de réalisation et des rendements de fabrication. Lorsque les circuits électroniques sont reliés par des fils, il est toujours délicat de maîtriser l'écartement des fils de liaison, et un approchement substantiel de fils de liaison peut entraîner une mise en contact de ceux-ci, et partant un court-circuit. Dès lors, l'impédance caractéristique d'une ligne bifilaire réalisée au moyen de fils peut être typiquement très supérieure à 50 Ohms.

Cet inconvénient est d'autant plus critique que les assemblages considérés sont complexes et que de longues chaînes de dimensions sont impliquées. Par exemple, dans un cas relativement simple où des puces ou des modules de puissance sont montés sur des dissipateurs thermiques, au travers de cavités réalisées dans un substrat, une chaîne de dimensions peut être définie comme la somme de la distance de la plage de connexion sur le substrat par rapport au bord du substrat, de la distance du bord du substrat au bord de la puce ou du module, et de la distance du bord de la puce ou du module, à la plage de connexion sur la puce ou le module. Une tolérance fine associée à une telle chaîne de dimensions est réalisable en pratique, mais au prix de procédés de fabrication et de contrôle nécessairement coûteux, et au risque d'un rendement faible.

Un autre problème se posant dans ce contexte, est lié au fait qu'il est parfois nécessaire de relier des composants dans des assemblages dans lesquels ceux-ci présentent des points de fixation situés à des hauteurs différentes. Dans de tels cas, non seulement la différence de hauteur entre les composants ou circuits accroit la longueur de liaison, mais en outre la réalisation d'un retour de masse s'avère délicate.

Il existe des solutions connues de l'état de la technique, mises en œuvre pour limiter l'influence des phénomènes parasites ou la désadaptation des connexions.

Une première technique connue consiste à utiliser des broches de connexion, dont les formes peuvent être diverses. Ces broches de connexion peuvent par exemple être des pointes traversantes, des lyres, ou encore des broches plates montées en surface de circuits imprimés. Un inconvénient de cette technique est qu'elle n'est pas efficace pour la transmission de signaux à haute fréquence, et pour la dissipation de fortes puissances.

Une deuxième technique connue consiste à utiliser un micro-câblage comprenant une pluralité de fils conducteurs en parallèle, habituellement deux fils. Une telle technique est cependant souvent limitée par la surface disponible sur les plages de connexion, dont la surface est limitée par la fréquence des signaux à transmettre. Elle est également limitée par le phénomène d'inductance mutuelle entre les fils conducteurs.

Une troisième technique connue consiste à utiliser un micro-câblage comprenant des micro-rubans. Cette technique présente cependant également l'inconvénient d'être limitée par la surface disponible sur les plages de connexion, dont la surface est limitée par la fréquence des signaux à transmettre. Un autre inconvénient de cette technique est qu'elle est nettement plus coûteuse à mettre en œuvre de manière industrielle, en comparaison avec la deuxième technique filaire précitée.

Une quatrième technique connue consiste à utiliser des microbilles conductrices, brasées entre des plages métallisées de modules montés retournés les uns par rapport aux autres. Cette technique est connue sous le nom de technique de "puce retournée", et plus habituellement désignée selon la terminologie anglo-saxonne "flip-chip". Par exemple, une puce électronique ou un module équipé d'une matrice de billes conductrices - souvent désignée selon le sigle BGA, de l'expression anglo-saxonne "Ball Grid Array" - monté retourné sur un substrat. Cette technique est avantageuse pour des liaisons à très haute fréquence, et/ou à très large bande de fréquences. Cependant, cette technique est coûteuse à mettre en œuvre de manière industrielle, et requiert des étapes supplémentaires dans le procédé de fabrication des dispositifs les mettant en œuvre. En outre, cette technique présente l'inconvénient de ne pas être efficace en termes de dissipation thermique, lorsqu'elle est appliquée à des circuits électroniques monolithiques, de type puce. Elle peut s'avérer efficace lorsqu'elle est appliquée à des modules intégrant un dissipateur thermique, mais dans de tels cas la technique s'avère globalement très coûteuse à mettre en œuvre de manière industrielle. Cette technique présente également l'inconvénient de nécessiter des puces ou des modules conçus spécifiquement pour ce type d'assemblages. Elle présente enfin un inconvénient lié à la difficulté, voire l'impossibilité, de réaliser des contrôles visuels sur les liaisons après assemblage.

Une cinquième technique connue consiste à utiliser des micro-plages de connexion, assemblées directement par brasure ou par collage sur des circuits électroniques montés retournés l'une par rapport à l'autre. Cette technique est similaire à la quatrième technique connue utilisant des microbilles, décrite ci-dessus. Par exemple, une puce électronique ou un module équipé d'une matrice de micro-plages métallisées de connexion - souvent désignée selon le sigle LGA, de l'expression anglo-saxonne "Land Grid Array" - monté retourné sur un substrat. Cette technique permet également de réaliser des liaisons à très haute fréquence et/ou très large bande. En revanche, cette technique n'est pas efficace pour assurer l'adaptation des différences de coefficients de dilatation entre les différents circuits électroniques. D'une manière similaire à la quatrième technique décrite ci-dessus, cette technique présente l'inconvénient de ne pas être efficace en termes de dissipation thermique, lorsqu'elle est appliquée à des circuits électroniques monolithiques, de type puce. Elle peut également s'avérer efficace lorsqu'elle est appliquée à des modules intégrant un dissipateur thermique, mais au prix d'une mise en œuvre très coûteuse. Cette technique présente également l'inconvénient de nécessiter des puces ou des modules conçus spécifiquement pour ce type d'assemblages. Elle présente également un inconvénient lié à la difficulté, voire l'impossibilité, de réaliser des contrôles visuels des liaisons après assemblage, même lorsque certaines liaisons sont réalisées avec des plages qui remontent sur les côtés, par exemple pour des modules munis de castellations, selon des techniques spécifiques au LGA.

Une sixième technique connue consiste à utiliser des micro-plots de connexion destinés à la réalisation de liaisons par thermo-compression ou par collage. Cette technique permet la réalisation de liaisons à très haute fréquence et/ou à très large bande de fréquences. Cependant, cette technique ne permet pas d'assurer une dissipation thermique efficace. Elle présente également un inconvénient lié à la difficulté, voire l'impossibilité, de réaliser des contrôles visuels des liaisons après assemblage.

Une septième technique connue consiste en un collage automatique par bande, cette technique est habituellement désignée selon l'acronyme "TAB", pour l'expression anglo-saxonne de "Tape Automated Bonding". Cette technique se base sur un circuit électrique réalisé sur un substrat fin et souple, dont les pistes dépassent et sont directement micro-câblées sur les plots d'interconnexion des éléments à relier, par exemple par thermo-compression ou par brasure collective. Cette technique permet un mode de liaison collectif, c'est-à-dire que toutes les opérations de connexion pour un même circuit imprimé, peuvent être réalisées de manière simultanée. La technique TAB permet par exemple la réalisation de liaisons avec des lignes de transmission coplanaires, de type masse / signal / masse. De telles lignes présentent l'inconvénient d'être sensibles aux dissymétries, de nécessiter un minimum de six points de contact par liaison, de nécessiter des plans de masse de large surface, ainsi qu'une grande finesse dans la réalisation de la ligne centrale, en termes de largeur de piste et d'écart avec les lignes de masse, dans le but d'obtenir des impédances caractéristiques typiques de l'ordre de 50 Ω.

Les demandes de brevets japonaises JP2004296468 A, JP2009158839 A, le brevet japonais JP2897086 B2 et la demande de brevet américaine US2009079081 A1 décrivent différents appareils de mise en forme de fils d'interconnexion.

Un but de la présente invention est de pallier les inconvénients propres aux dispositifs connus précités, en proposant un procédé d'interconnexion pour circuits électroniques hyperfréquence, formé par au moins deux fils conducteurs, les fils étant, rapprochés et/ou mis en forme de sorte que la liaison ainsi pouvant se substituer aux techniques connues d'interconnexion, le plus souvent filaires, ou également aux lignes de transmission coplanaires de type masse / signal / masse utilisées pour la réalisation de liaisons selon des techniques de type TAB. Un procédé d'interconnexion selon l'invention permet la transmission de signaux électriques occupant une large bande de fréquences et/ou se situant à des fréquences élevées en regard des dimensions à réaliser et/ou présentant des puissances élevées, avec un niveau d'adaptation élevé.

La présente invention propose de relier électriquement les circuits électroniques au moyen d'un élément formant une ligne de transmission de longueur et d'impédance caractéristique appropriées, formé par des fils parallèles couplés.

Un avantage de l'invention est de permettre la réalisation de liaisons électriques de type ligne à transmission, dont les dimensions permettent de relâcher les éléments d'une chaîne de dimensions, et d'éloigner les éléments interconnectés.

Encore un autre avantage de l'invention est qu'elle permet de tolérer des variations de dimensions liées aux possibles variations de températures et aux différents coefficients de dilatation des matériaux mis en œuvre, pouvant typiquement induire des mouvements relatifs de l'ordre du micron.

Encore un autre avantage de l'invention est qu'un dispositif selon l'un des modes de réalisation décrits peut être réalisé au moyen d'un outillage usuel de micro-câblage. Un outillage de mise en forme des fils est proposé pour chacune des réalisations possibles. Ces outillages relativement simples peuvent être mis en œuvre sur la plupart des équipements de micro-câblage ou de placement automatisé de composants électroniques. Les formes des dispositifs proposés sont étroitement liées aux outils de mise en forme proposés.

A cet effet, l'invention a pour objet un procédé d'interconnexion selon la revendication 1.

Dans un mode de réalisation du procédé, à l'issue de l'étape de mise en forme, les fils se chevauchent sur au moins une partie de leur longueur le long de laquelle au moins un fil est recouvert de l'isolant.

Dans un autre mode de réalisation du procédé, à l'issue de l'étape de mise en forme, les fils présentent une configuration rectiligne, les fils étant au moins sur cette portion disposés sensiblement en parallèle l'un de l'autre.

Avantageusement, à l'issue de l'étape de mise en forme, les fils sont rapprochés sur la plus grande longueur disponible de ceux-ci.

L'étape de mise en forme peut être suivie d'une étape d'enrobage lors de laquelle au moins un fil est enrobé d'un matériau diélectrique sur au moins une partie de sa longueur.

Le matériau diélectrique peut enrober globalement lesdits au moins deux fils sur au moins une partie de leur longueur. Alternativement, chaque fil peut être indépendamment enrobé au moins sur une partie de sa longueur du matériau diélectrique.

L'étape d'enrobage peut être à son tour suivie d'une étape additionnelle de disposition d'éléments conducteurs disposés au contact des diamètres extérieurs desdits au moins deux fils ; entre les fils, le nombre et la nature des éléments conducteurs étant configurés de manière à procurer une adaptation d'impédance souhaitée au dispositif d'interconnexion.

L'invention a également pour objet un outil selon la revendication 9.

Dans une machine portant l'outil et les éléments à interconnecter, les éléments peuvent rester fixes et l'outil se déplace. De façon équivalente, l'outil peut être fixe et les mouvements sont appliqués aux éléments à interconnecter.

Les mouvements relatifs de translation peuvent être horizontaux et verticaux.

Avantageusement, la tête de l'outil est apte à se déplacer relativement par rapport auxdits au moins deux fils en translation le long d'au moins une partie de la longueur desdits au moins deux fils et comprend deux gorges aptes à recevoir chacun desdits au moins deux fils.

Dans le mode de réalisation du dispositif où les fils se chevauchent la tête de l'outil est apte à se déplacer relativement par rapport auxdits au moins deux fils en translation et en rotation le long d'au moins une partie de la longueur desdits au moins deux fils et comprend deux pions cylindriques.

D'autres caractéristiques et avantages de l'invention apparaîtront à la lecture de la description, donnée à titre d'exemple, faite en regard des dessins annexés qui représentent :
- la figure 1, une vue en perspective illustrant de manière simplifiée un dispositif d'interconnexion suivant un exemple de réalisation de l'invention ;
- la figure 2, des vues en perspective illustrant la mise en forme d'un dispositif d'interconnexion au moyen d'un outillage spécifique, dans un exemple de réalisation de l'invention ;
- la figure 3, des vues en perspective illustrant la mise en forme d'un dispositif d'interconnexion au moyen d'un outillage spécifique, dans un autre exemple de réalisation de l'invention ;
- les figures 4A et 4B, des vues en perspective illustrant de manière simplifiée des dispositifs d'interconnexions suivant des exemples de réalisation alternatifs de l'invention ;
- les figures 5A et 5B, des vues en perspective illustrant de manière simplifiée des dispositifs d'interconnexions suivant des exemples de réalisation alternatifs de l'invention ;
- les figures 6A, 6B, des vues en perspective illustrant de manière simplifiée des dispositifs d'interconnexions suivant des exemples de réalisation alternatifs de l'invention.

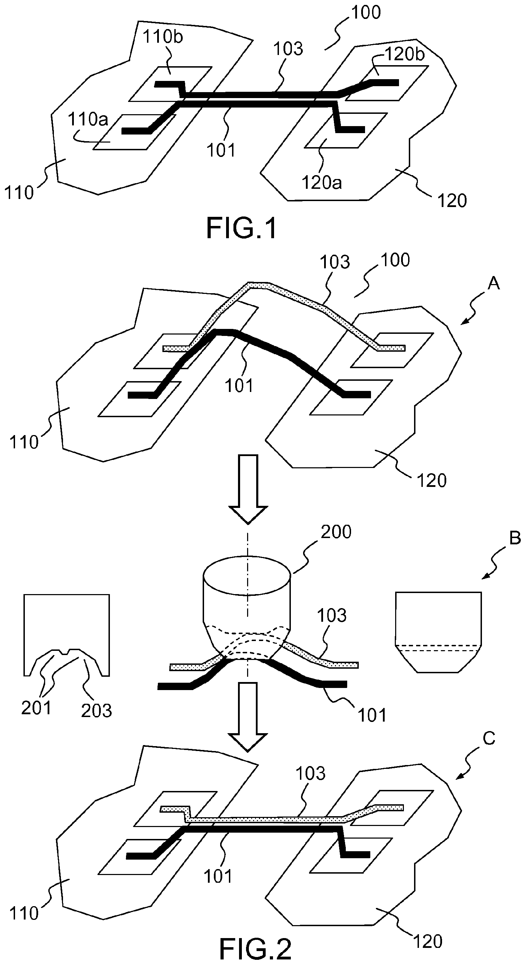

La figure 1 présente une vue en perspective illustrant de manière simplifiée un dispositif d'interconnexion 100 suivant un exemple de réalisation de l'invention.

Le dispositif d'interconnexion 100 permet dans l'exemple illustré par la figure, l'interconnexion entre deux éléments 110, 120, par exemple des circuits ou modules électroniques. Chaque élément à interconnecter 110, 120 peut comprendre des plages d'interconnexion. Dans l'exemple illustré par la figure 1, le premier élément 110 peut comprendre deux plages d'interconnexion 110a, 110b et le second élément 120 peut comprendre deux plages d'interconnexion 120a, 120b.

Le dispositif d'interconnexion peut comprendre une ligne bifilaire formée par un premier fil 101, par exemple fil de masse, couplé à un second film 103, par exemple fil de signal. Le premier fil 101 peut être connecté au premier élément 110 via la première plage d'interconnexion 110a de celui-ci, et au second élément 120 via la première plage d'interconnexion 120a de ce dernier. D'une manière similaire, le second fil 103 peut être connecté au premier élément 110 via la seconde plage d'interconnexion 110b de celui-ci, et au second élément 120 via la seconde plage d'interconnexion 120b de ce dernier.

Les deux fils 101, 103 sont dans l'exemple illustré par la figure sensiblement parallèle, au moins sur une portion de ceux-ci. Selon une spécificité de la présente invention, au moins un des deux fils 101, 103 est recouvert d'une couche d'un matériau électriquement isolant. Des fils recouverts d'isolant sont en eux-mêmes connus, et peuvent être pourvus selon des circuits d'approvisionnement connus. D'une manière typique, la longueur de la liaison électrique assurée par le dispositif d'interconnexion 100 peut être de l'ordre de 100 µm, à quelques millimètres. L'épaisseur de la couche d'isolant sur au moins un des fils peut être de l'ordre du micromètre.

Le matériau isolant permet aux fils 101, 103 d'être possiblement physiquement en contact, sans qu'une liaison électrique ne puisse pour autant être établie entre les deux fils 101, 103. Avantageusement, les deux fils 101, 103 peuvent être recouverts d'isolant.

Les fils 101, 103 peuvent être disposés et mis en forme suivant des techniques de micro-câblage en elles-mêmes connues, c'est-à-dire qu'un procédé de mise en œuvre d'un dispositif d'interconnexion, dit pour la suite procédé d'interconnexion suivant la présente invention peut être dérivé d'un procédé connu de micro-câblage. Les fils 101, 103 peuvent par exemple être disposés dans une première étape de micro-câblage, puis mis en forme dans une étape de mise en forme, de manière à être approchés l'un de l'autre et de façon à obtenir une adaptation d'impédance souhaitée pour l'application envisagée. Les fils 101, 103 peuvent être rapprochés sur la plus grande longueur disponible de ceux-ci, c'est-à-dire que le rapprochement mutuel des fils 101, 103 est réalisé au plus près des plages d'interconnexion 110a, 110b et 120a, 120b.

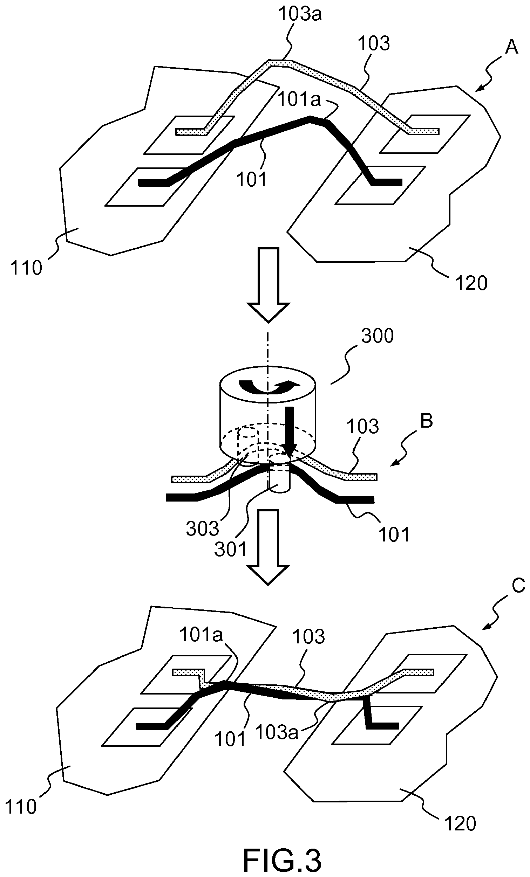

L'exemple illustré par la figure 1 présente une configuration rectiligne des fils 101, 103, mais une multitude de formes alternatives peuvent être envisagées, les fils 101, 103 pouvant par exemple se chevaucher, ainsi que dans l'exemple illustré par les figures 3, 4B ou 6B.

D'une manière typique, la gamme d'impédances pouvant être réalisée au moyen d'un dispositif d'interconnexion suivant la présente invention peut notamment couvrir les valeurs typiques nominales de 30, 50 et 75 Ohms. La bande de fréquence visée peut être de l'ordre de quelques dizaines de GHz ou plus.
La figure 2 présente des vues en perspective illustrant la mise en forme d'un dispositif d'interconnexion au moyen d'un outillage spécifique, dans un exemple de réalisation de l'invention.
La figure 2 présente une première configuration A dans laquelle deux éléments à interconnecter 110, 120 ont été reliés lors d'une étape de micro-câblage par une liaison bifilaire comprenant un premier fil 101 et un second fil 103, les extrémités des fils 101, 103 ayant été fixées à des plages d'interconnexion, par exemple ou moyen de soudure, de brasure, de collage ou de tout autre moyen approprié.

Dans une deuxième configuration B illustrée par la figure 2, les fils 101, 103 peuvent, lors d'une étape de mise en forme, être portés dans une disposition illustrée par une troisième configuration C, similaire à la disposition décrite précédemment en référence à la figure 1, au moyen d'un outil approprié 200. L'outil 200 peut notamment comprendre une tête pouvant être amenée lors de l'étape de mise en forme au contact des deux fils 101, 103. Un mouvement de translation verticale peut être appliqué à la tête de l'outil 200 de manière à ce que les fils 101, 103 soient mis en forme sur une longueur déterminée, avantageusement la plus longue possible ainsi que décrit précédemment. La tête de l'outil 200 peut être profilée de manière à accueillir les diamètres extérieurs des deux fils 101, 103. Ainsi que dans l'exemple illustré par la figure 2, la tête de l'outil 200 peut comprendre deux gorges 201, 203 prévues à cet effet.

La translation verticale est de façon conventionnelle définie par rapport à un plan horizontal dans lequel peuvent se situer les plages d'interconnexion 110a, 110b du premier élément 110 ainsi que les plages d'interconnexion 120a, 120b du second élément 120. Dans ce cas, le fond de chacune des gorges 201 et 203 est disposé dans un plan horizontal.

Il est également possible de réaliser l'interconnexion d'éléments dont les plages sont situées à des hauteurs différentes, c'est-à-dire dans des plans horizontaux différents, voire dans des plans inclinés par rapport à un plan horizontal. Les formes des gorges 201 et 203 sont adaptées en conséquence et sont alors disposées dans des plans inclinés par rapport à un plan horizontal.

Il est possible de réaliser au moyen d'une telle structure des impédances caractéristiques typiquement très supérieures à 50 Ohms.

La figure 3 présente des vues en perspective illustrant la mise en forme d'un dispositif d'interconnexion au moyen d'un outillage spécifique, dans un autre exemple de réalisation de l'invention.

D'une manière similaire à la figure 2 décrite ci-dessus, la figure 3 présente trois configurations A, B et C reflétant respectivement un dispositif d'interconnexion à l'issue d'une étape de micro-câblage, pendant une étape de mise en forme, et à l'issue de l'étape de mise en forme. La disposition des fils 101, 103 à l'issue de l'étape de mise en forme est, dans l'exemple de la figure 3, différente de la disposition présentée dans la figure 2 ou la figure 1. Dans l'exemple de la figure 3 illustré par la troisième configuration C, les fils 101, 103 peuvent se chevaucher au moins sur une partie de leur longueur, de manière à favoriser le couplage entre les fils et de renforcer également la structure bifilaire. Une structure bifilaire réalisée de la sorte présente notamment l'avantage d'être moins sensible aux vibrations et aux chocs mécaniques. Elle permet également d'assurer de plus grandes longueurs d'interconnexion.

Il ne s'agit pas d'une paire de fils torsadés qui serait beaucoup plus compliquée à mettre en œuvre. En effet, les fils torsadés sont enroulés l'un par rapport à l'autre avant de finaliser les opérations de câblage. Les deux fils d'une paire de fils torsadés doivent être mis à longueur, dénudés et raccordés sur les plages simultanément. Ceci est très délicat à réaliser notamment pour des longueurs de fils inférieures à 1mm. Le chevauchement est en revanche réalisé à l'aide de deux fils unitaires séparés mis à longueur, dénudés et raccordés séparément l'un de l'autre. Après raccordement des deux fils sur leurs plages d'interconnexion respectives, le chevauchement consiste à faire passer un des fils au dessus de l'autre au moins sur une partie de sa longueur.

Une telle mise en forme peut être obtenue par l'application d'un outil spécifique 300 comprenant au moins une tête, la tête de l'outil 300 étant configurée de manière à pouvoir garantir la mise en forme souhaitée aux deux fils 101, 103, par exemple lorsque la tête de l'outil 300 est animée d'un mouvement de rotation autour de son axe principal par des moyens appropriés, non représentés sur la figure, ainsi que d'un mouvement de translation verticale le long de la portion d'intérêt des fils 101, 103, c'est-à-dire le long de la portion le long de laquelle il est souhaité que les fils 101, 103 soient chevauchés. Ainsi que dans l'exemple illustré par la figure 3, le profil de la tête peut être formé par deux pions cylindriques 301, 303 ou des galets, dont les diamètres extérieurs viennent au contact des diamètres extérieurs des fils 101, 103.

Pour faciliter le chevauchement alternatif des deux fils 101 et 103, il est possible de former les fils 101 et 103 de façon non parallèle lors de leur raccordement sur leurs plages respectives avant application de l'outil 300. Plus précisément, chacun des fils 101 et 103 peut posséder un sommet, respectivement 101a et 103a. Le sommet 101a est disposé plus près de l'élément 120 que de l'élément 110. Inversement, le sommet 103a est disposé plus près de l'élément 110 que de l'élément 120. De façon plus générale, les sommets 101a et 103a sont disposés à des cotes différentes, cotes mesurées le long des fils du premier élément 110 vers le second élément 120. Ainsi, lors de l'application de l'outil 300, le sommet 101a recouvre facilement le fil 103 et le sommet 103a recouvre facilement le fil 101.

Comme précédemment, les plages interconnexion peuvent ou non être disposées dans un même plan horizontal. Les formes des gorges 201 et 203 sont adaptées en conséquence.

Dans une machine portant les outils représentés sur les figures 2 et 3 et les éléments à interconnecter, les éléments peuvent rester fixes et l'outil correspondant se déplace. De façon équivalente, l'outil peut être fixe et les mouvements sont appliqués aux éléments à interconnecter.

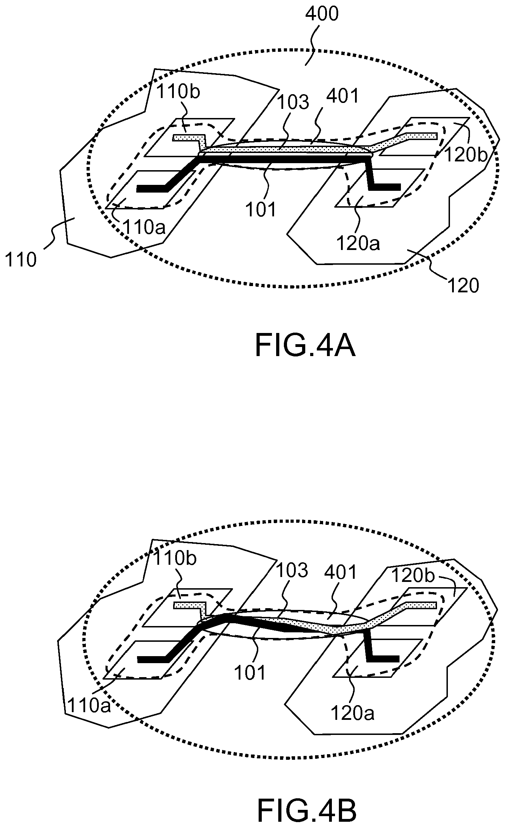

Les figures 4A et 4B présentent des vues en perspectives illustrant de manière simplifiée des dispositifs d'interconnexions suivant des exemples de réalisation alternatifs de l'invention.

En référence à la figure 4A, un dispositif d'interconnexion 400 peut être formé par une ligne bifilaire comprenant deux fils 101, 103 dans une configuration similaire à la configuration décrite précédemment en référence à la figure 1. Avantageusement, au moins une partie de la longueur de la ligne bifilaire, par exemple au moins une partie de la portion des fils 101, 103 le long de laquelle ceux-ci sont sensiblement rectilignes et parallèles l'un à l'autre dans cet exemple de réalisation, peut être globalement enrobée par un matériau diélectrique 401.

Avantageusement encore, l'enrobage par le diélectrique 401 peut s'étendre plus largement encore, par exemple sur toute la longueur des fils 101, 103, voire également sur les plages d'interconnexion 110a, 110b et 120a, 120b respectivement des deux éléments à interconnecter 110, 120, c'est-à-dire dans une région illustrée par les traits pointillés dans la figure 4A.

Maintenant en référence à la figure 4B, les mêmes caractéristiques peuvent également s'appliquer à une configuration des fils 101, 103 alternative dans laquelle les fils 101, 103 se chevauchent alternativement, à l'instar du mode de réalisation décrit précédemment en référence à la figure 3. Ainsi, au moins une partie de la longueur de la ligne bifilaire, par exemple au moins une partie de la portion des fils 101, 103 le long de laquelle ceux-ci sont chevauchés dans cet exemple de réalisation, peut être globalement enrobée par un matériau diélectrique 401.

Avantageusement encore, l'enrobage par le diélectrique 401 peut s'étendre plus largement encore, par exemple sur toute la longueur des fils 101, 103, voire également sur les plages d'interconnexion 110a, 110b et 120a, 120b respectivement des deux éléments à interconnecter 110, 120, c'est-à-dire dans une région illustrée par les traits pointillés dans la figure 4A.

Une interconnexion par un dispositif d'interconnexion 400 suivant l'un des modes de réalisation illustrés par les figures 4A et 4B peut être réalisée par un procédé dans lequel une étape additionnelle d'enrobage, faisant suite à l'étape de mise en forme précitée, permet la réalisation de l'enrobage de diélectrique 401.

D'une manière typique, les modes de réalisation illustrés par les figures 4A et 4B peuvent permettre la réalisation d'impédances caractéristiques proches ou supérieures à 50 Ohms.

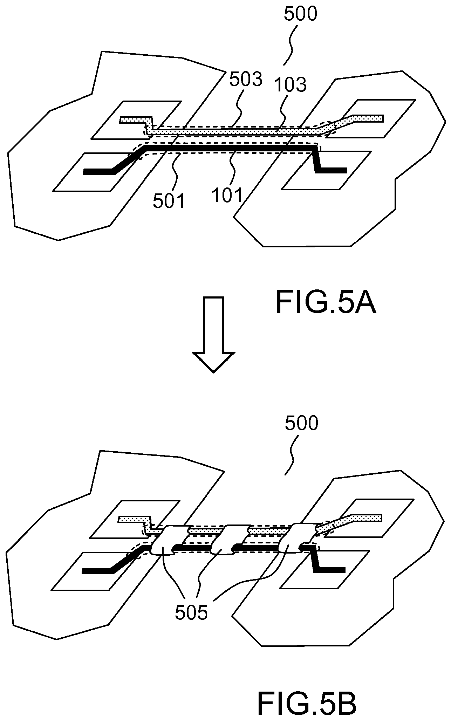

Les figures 5A et 5B présentent des vues en perspective illustrant de manière simplifiée des dispositifs d'interconnexions suivant des exemples de réalisation alternatifs de l'invention.

En référence à la figure 5A, un dispositif d'interconnexion 500 peut être formé par une ligne bifilaire comprenant deux fils 101, 103 dans une configuration similaire à la configuration décrite précédemment par exemple en référence à la figure 1. Avantageusement, au moins une partie de la longueur de chaque fil 101, 103, par exemple au moins une partie de la portion de chaque fil 101, 103 le long de laquelle les fils 101, 103 sont sensiblement rectilignes et parallèles l'un à l'autre dans cet exemple de réalisation, peut être globalement enrobée par un matériau diélectrique 501, 503. Dans ce mode de réalisation, au moins un fil peut être isolé à l'instar des modes de réalisation décrits précédemment, voire les deux fils 101, 103 peuvent ne pas être isolés et simplement enrobés de matériau diélectrique.

Maintenant en référence à la figure 5B, un dispositif d'interconnexion 500 tel que décrit ci-dessus peut avantageusement comprendre un ou une pluralité d'éléments conducteurs 505 disposés au contact des diamètres extérieurs des fils 101, 103 recouverts de matériau diélectrique 501, 503. Les éléments conducteurs 505 permettent d'ajuster l'adaptation d'impédance.

Un dispositif d'interconnexion 500 selon le mode de réalisation décrit en référence à la figure 5B peut permettre d'une manière typique la réalisation d'impédances caractéristiques proches ou inférieures à 50 Ohms.

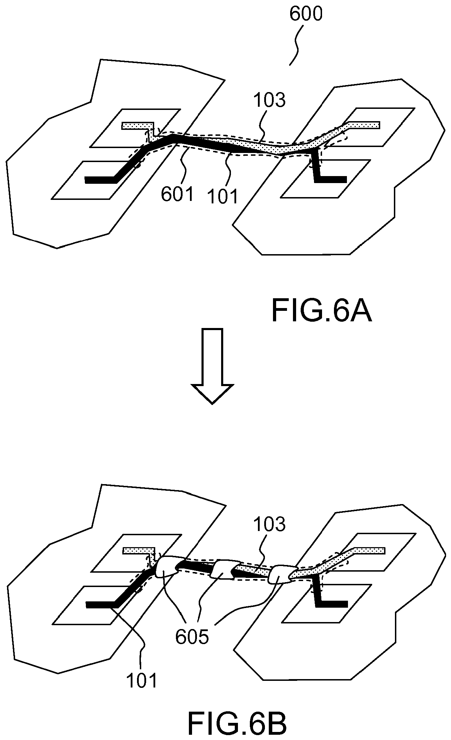

Les figures 6A et 6B présentent des vues en perspective illustrant de manière simplifiée des dispositifs d'interconnexions suivant des exemples de réalisation alternatifs de l'invention.
La figure 6A présente un mode de réalisation similaire au mode de réalisation illustré par la figure 4B décrite précédemment, dans lequel les fils 101, 103 formant la ligne bifilaire d'un dispositif d'interconnexion 600 sont chevauchés, et recouverts d'un matériau diélectrique 601.
La figure 6B illustre un dispositif d'interconnexion similaire au dispositif d'interconnexion 600 illustré par la figure 6A, comprenant en outre un ou une pluralité d'éléments conducteurs 605 disposés au contact de la surface extérieure de l'enrobage de matériau diélectrique 601 réalisé autour des fils 101, 103.

Une interconnexion au moyen de dispositifs d'interconnexion suivant les modes de réalisation décrits ci-dessus en référence aux figures 5B et 6B, c'est-à-dire comprenant des éléments conducteurs, peut être réalisée au moyen d'un procédé comprenant, outre les étapes de micro-câblage, de mise en forme et d'enrobage précitées, une étape additionnelle de disposition des éléments conducteurs. Les éléments conducteurs peuvent par exemple être disposés par sertissage, par collage, soudage ou par toute autre technique appropriée.

Il est à noter que dans les différents modes de réalisation présentés ci-dessus, les liaisons bifilaires sont réalisées exclusivement au moyen des fils, de leur isolant et possiblement d'un enrobage global localisé et/ou d'un enrobage de diélectrique et/ou d'éléments conducteurs. Ces structures ne requièrent notamment pas la présence d'un blindage externe.

Il est à observer que les modes de réalisation décrits précédemment sont des exemples non-limitatifs de la présente invention. Des combinaisons des caractéristiques présentées dans les différents modes de réalisation peuvent notamment être combinées. Selon le même concept inventif, il est également notamment possible de réaliser des liaisons tri-filaires ou multifilaires, par exemple des liaisons de type Masse / Signal / Masse.

Egalement, il est possible de réaliser des liaisons pour l'interconnexion de plusieurs éléments, par exemple trois éléments, au moyen d'une pluralité de fils présentant plusieurs zones aptes à être fixées et reliées électriquement à des plages d'interconnexion des éléments à interconnecter. Par exemple, une liaison bifilaire peut être formée par deux fils conducteurs dont les extrémités de chacun sont reliées à des plages d'interconnexion de deux premiers éléments à interconnecter, à l'instar des modes de réalisation décrits ci-dessus, et dont une partie centrale de chacun est dénudée de manière à pouvoir être fixée à des plages de connexion d'un troisième élément à interconnecter, disposé sensiblement entre les deux premiers éléments à interconnecter.

Un autre avantage de la présente invention est qu'elle permet une interconnexion d'éléments dont les plages d'interconnexion sont disposées à des hauteurs différentes, par exemple par rapport au plan principal d'une carte de circuit électronique sur laquelle les éléments à interconnecter sont fixés. L'interconnexion ainsi réalisée est en outre robuste vis-à-vis de possibles variations de température pouvant engendrer des variations des hauteurs ou distances relatives des différents éléments à interconnecter, ou bien à des vibrations ou autres sollicitations mécaniques.

## Revendications

1. Procédé d'interconnexion pour le transit de signaux hyperfréquences entre des éléments (110, 120) à interconnecter tels que des modules ou circuits électroniques, comprenant au moins deux lignes couplées formées par au moins deux fils (101, 103) aptes à être reliés électriquement à des plages d'interconnexion (110a, 110b, 120a, 120b) des éléments (110, 120) à interconnecter, au moins un des fils étant recouvert d'un isolant sur au moins une portion de celui-ci, **caractérisé en ce qu'**il comprend au moins une étape de micro-câblage lors de laquelle les fils (101, 103) sont reliés aux plages d'interconnexion (110a, 110b, 120a, 120b) des éléments (110, 120) à interconnecter, suivie d'une étape de rapprochement et/ou de mise en forme desdits au moins deux fils (101, 103) lors de laquelle lesdits au moins deux fils (101, 103) sont disposés dans leur configuration souhaitée de sorte à fournir une adaptation d'impédance souhaitée entre les éléments (110, 120) à interconnecter.

2. Procédé d'interconnexion suivant la revendication 1, **caractérisé en ce qu'**à l'issue de l'étape de mise en forme, les fils (101, 103) se chevauchent sur au moins une partie de leur longueur le long de laquelle au moins un fil est recouvert de l'isolant.

3. Procédé d'interconnexion suivant la revendication 1, **caractérisé en ce qu'**à l'issue de l'étape de mise en forme, les fils (101, 103) présentent une configuration rectiligne, les fils (101, 103) étant au moins sur cette portion disposés sensiblement en parallèle l'un de l'autre.

4. Procédé suivant l'une des revendications précédentes **caractérisé en ce qu'**à l'issue de l'étape de mise en forme, les fils (101, 103) sont rapprochés sur la plus grande longueur disponible de ceux-ci.

5. Procédé suivant l'une des revendications précédentes **caractérisé en ce que** l'étape de mise en forme est suivie d'une étape d'enrobage lors de laquelle au moins un fil (101, 103) est enrobé d'un matériau diélectrique (401, 501, 503, 601) sur au moins une partie de sa longueur.

6. Procédé d'interconnexion suivant la revendication 5, **caractérisé en ce que** le matériau diélectrique (401) enrobe globalement lesdits au moins deux fils (101, 103) sur au moins une partie de leur longueur.

7. Procédé d'interconnexion suivant la revendication 5, **caractérisé en ce que** chaque fil (101, 103) est indépendamment enrobé au moins sur une partie de sa longueur du matériau diélectrique (401).

8. Procédé d'interconnexion suivant l'une des revendications 5 à 7, **caractérisé en ce que** l'étape d'enrobage est suivie d'une étape additionnelle de disposition d'éléments conducteurs (505, 605) disposés au contact des diamètres extérieurs desdits au moins deux fils (101, 103), entre les fils (101, 103), le nombre et la nature des éléments conducteurs (505, 605) étant configurés de manière à procurer une adaptation d'impédance souhaitée au dispositif d'interconnexion (100, 500).

9. Outil (200, 300) pour la mise en œuvre d'un procédé d'interconnexion suivant l'une quelconque des revendications précédentes, comprenant une tête apte à se déplacer relativement par rapport auxdits au moins deux fils (101, 103) en translation et/ou en rotation le long d'au moins une partie de la longueur desdits au moins deux fils (101, 103), le profil de la tête étant configuré pour rapprocher et/ou mettre en forme les fils (101, 103) de manière à les porter dans une configuration souhaitée lors du mouvement de la tête de sorte à fournir une adaptation d'impédance souhaitée entre les éléments (110, 120) à interconnecter.

10. Outil (200) selon la revendication 9, **caractérisé en ce que** la tête est apte à se déplacer relativement par rapport auxdits au moins deux fils (101, 103) en translation, et comprend deux gorges (201, 203) aptes à recevoir chacun desdits au moins deux fils (101, 103).

11. Outil (300) selon la revendication 9, **caractérisé en ce que** la tête est apte à se déplacer relativement par rapport auxdits au moins deux fils (101, 103) en translation et en rotation, et comprend deux pions cylindriques (301, 303).

## Patentansprüche

1. Verbindungsverfahren für die Übertragung von Mikrowellensignalen zwischen miteinander zu verbindenden Elementen (110, 120) wie elektronischen Modulen oder Schaltkreisen, mit mindestens zwei durch mindestens zwei Drähte (101, 103) gebildeten gekoppelten Leitungen, die mit Verbindungsbereichen (110a, 110b, 120a, 120b) der miteinander zu verbindenden Elemente (110, 120) elektrisch verbunden werden können, wobei mindestens einer der Drähte (101, 103) auf mindestens einem Abschnitt davon mit einem Isolator bedeckt ist, **dadurch gekennzeichnet, dass** es mindestens einen Mikroverdrahtungsschritt beinhaltet, bei dem die Drähte (101, 103) mit den Verbindungsbereichen (110a, 110b, 120a, 120b) der miteinander zu verbindenden Elemente (110, 120) verbunden werden, gefolgt von einem Schritt des Zueinanderhinbringens und/oder Formens der mindestens zwei Drähte (101, 103), bei dem die mindestens zwei Drähte (101, 103) in ihrer gewünschten Konfiguration angeordnet sind, um eine gewünschte Impedanzanpassung zwischen den miteinander zu verbindenden Elementen (110, 120) zu erzielen.

2. Verbindungsverfahren nach Anspruch 1, **dadurch gekennzeichnet, dass** sich die Drähte (101, 103) nach dem Formungsschritt über mindestens einen Teil ihrer Länge überlappen, über dem mindestens ein Draht durch den Isolator bedeckt ist.

3. Verbindungsverfahren nach Anspruch 1, **dadurch gekennzeichnet, dass** die Drähte (101, 103) nach dem Formungsschritt eine geradlinige Konfiguration aufweisen, wobei die Drähte (101, 103) zumindest auf diesem Abschnitt im Wesentlichen parallel zueinander angeordnet sind.

4. Verfahren nach einem der vorhergehenden Ansprüche, **dadurch gekennzeichnet, dass** die Drähte (101, 103) nach dem Formungsschritt über ihre größte verfügbare Länge zueinander hin gebracht werden.

5. Verfahren nach einem der vorhergehenden Ansprüche, **dadurch gekennzeichnet, dass** auf den Formungsschritt ein Umhüllungsschritt folgt, bei dem mindestens ein Draht (101, 103) über mindestens einen Teil seiner Länge mit einem elektrischen Material (401, 501, 503, 601) umhüllt wird.

6. Verbindungsverfahren nach Anspruch 5, **dadurch gekennzeichnet, dass** das dielektrische Material (401) die mindestens zwei Drähte (101, 103) über mindestens einen Teil ihrer Länge insgesamt umhüllt.

7. Verbindungsverfahren nach Anspruch 5, **dadurch gekennzeichnet, dass** jeder Draht (101, 103) unabhängig über mindestens einen Teil seiner Länge mit dem dielektrischen Material (401) umhüllt ist.

8. Verbindungsverfahren nach einem der Ansprüche 5 bis 7, **dadurch gekennzeichnet, dass** auf den Umhüllungsschritt ein zusätzlicher Schritt des Anordnens von leitenden Elementen (505, 605), die in Kontakt mit den Außendurchmessern der mindestens zwei Drähte (101, 103) sind, zwischen den Drähten (101, 103) folgt, wobei Anzahl und Beschaffenheit der leitenden Elemente (505, 605) so konfiguriert sind, dass sie eine gewünschte Impedanzanpassung der Verbindungsvorrichtung (100, 500) verleihen.

9. Werkzeug (200, 300) zum Durchführen eines Verbindungsverfahrens nach einem der vorhergehenden Ansprüche, das einen Kopf umfasst, der sich relativ zu den mindestens zwei Drähten (101, 103) translational und/oder rotational entlang mindestens eines Teils der Länge der mindestens zwei Drähte (101, 103) bewegen kann, wobei das Profil des Kopfs zum Zueinanderhinbringen und/oder Formen der Drähte (101, 103) konfiguriert ist, um sie bei der Bewegung des Kopfs in einer gewünschten Konfiguration zu tragen, um eine gewünschte Impedanzanpassung zwischen den miteinander zu verbindenden Elementen (110, 120) zu erzielen.

10. Werkzeug (200) nach Anspruch 9, **dadurch gekennzeichnet, dass** sich der Kopf relativ zu den mindestens zwei Drähten (101, 103) translational bewegen kann und zwei Nuten (201, 203) umfasst, die jeden der mindestens zwei Drähte (101, 103) aufnehmen können.

11. Werkzeug (300) nach Anspruch 9, **dadurch gekennzeichnet, dass** sich der Kopf relativ zu den mindestens zwei Drähten (101, 103) translational und rotational bewegen kann und zwei zylindrische Stifte (301, 303) umfasst.

## Claims

1. An interconnection method for conveying microwave signals between elements (110, 120) to be interconnected, such as electronic modules or circuits, comprising at least two coupled lines formed by at least two wires (101, 103) capable of being electrically connected to interconnection areas (110a, 110b, 120a, 120b) of the elements (110, 120) to be interconnected, with at least one of the wires being covered by an insulator on at least one portion thereof, **characterised in that** it comprises at least one step of micro-wiring, during which step the wires (101, 103) are connected to the interconnection areas (110a, 110b, 120a, 120b) of the elements (110, 120) to be interconnected, followed by a step of bringing together and/or of shaping said at least two wires (101, 103), during which step said at least two wires (101, 103) are disposed in their desired configuration so as to provide desired impedance matching between the elements (110, 120) to be interconnected.

2. The interconnection method as claimed in claim 1, **characterised in that**, on completion of the shaping step, the wires (101, 103) overlap on at least part of the length thereof, along which at least one wire is covered with insulator.

3. The interconnection method as claimed in claim 1, **characterised in that**, on completion of the shaping step, the wires (101, 103) have a straight configuration, the wires (101, 103) being disposed, at least on this portion, substantially parallel to each other.

4. The method as claimed in any one of the preceding claims, **characterised in that**, on completion of the shaping step, the wires (101, 103) are brought together on the longest available length thereof.

5. The method as claimed in any of the preceding claims, **characterised in that** the shaping step is followed by a coating step, during which step at least one wire (101, 103) is coated with a dielectric material (401, 501, 503, 601) on at least part of the length thereof.

6. The interconnection method as claimed in claim 5, **characterised in that** the dielectric material (401) generally coats said at least two wires (101, 103) on at least part of the length thereof.

7. The interconnection method as claimed in claim 5, **characterised in that** each wire (101, 103) is independently coated with the dielectric material (401) on at least part of the length thereof.

8. The interconnection method as claimed in any of claims 5 to 7, **characterised in that** the coating step is followed by an additional step of arranging conductive elements (505, 605) arranged in contact with the external diameters of said at least two wires (101, 103), between the wires (101, 103), with the number and the nature of the conductive elements (505, 605) being configured so as to provide the interconnection device (100, 500) with desired impedance matching.

9. A tool (200, 300) for implementing an interconnection method according to any one of the preceding claims, comprising a head capable of moving relatively in relation to said at least two wires (101, 103) by translation and/or by rotation along at least part of the length of said at least two wires (101, 103), the profile of the head being configured to bring together and/or shape the wires (101, 103) so that they can be supported in a desired configuration during the movement of the head, so as to provide desired impedance matching between the elements (110, 120) to be interconnected.

10. The tool (200) as claimed in claim 9, **characterised in that** the head is capable of moving relatively in relation to said at least two wires (101, 103) by translation, and comprises two grooves (201, 203) capable of accommodating each of said at least two wires (101, 103).

11. The tool (300) as claimed in claim 9, **characterised in that** the head is capable of moving relatively in relation to said at least two wires (101, 103) by translation and by rotation, and comprises two cylindrical pins (301, 303).
